# EUROPEAN PATENT SPECIFICATION

(11) **EP 2 506 070 B1**
(45) Date of publication and mention of the grant of the patent: **14.05.2014**
(21) Application number: 12162225.2
(22) Date of filing: 29.03.2012
(51) Int. Cl.: G02F 1/13357, G02B 6/00, G02F 1/1333, H05K 1/18, H05K 1/02

(54) **Liquid crystal display device**
Flüssigkristallanzeigevorrichtung
Dispositif d'affichage à cristaux liquides

(30) Priority: 29.03.2011 JP 2011071411
(43) Date of publication of application: 03.10.2012
(73) Proprietor: Japan Display Inc., Tokyo (JP)
(72) Inventor: Nakagawa, Atsuo, Tokyo (JP); Oohira, Eiji, Tokyo (JP)
(74) Representative: Beetz & Partner

(56) References cited:
- US-A1- 2006 187 373
- US-A1- 2009 225 253
- US-A1- 2009 310 054
- US-A1- 2010 110 328

## Description

### BACKGROUND OF THE INVENTION

### 1. Field of the Invention

The present invention relates to a liquid crystal display device.

### 2. Description of the Related Art

As liquid crystal display devices including a backlight, an example of using an FPC (Flexible Printed Circuit) mounting LEDs (Light Emitting Diodes) has been known. In an example shown in JP 2009-216753 A, an FPC is bent so as to extend from a liquid crystal display panel to the side of a back surface of a light guide plate of a backlight. LEDs mounted on the FPC are arranged so as to face an end face of the light guide plate.

Since the base material of the FPC is formed of a thin material so that the FPC is easily bent, wiring is susceptible to damage when bending stress is generated. Therefore, it is conceivable to attach a reinforcing plate to the FPC. However, when the reinforcing plate is attached, the thickness as the FPC is increased, making it difficult to meet the demand for a reduction in thickness of devices in recent years.

US 2009/0225253 A1 discloses a liquid crystal display device having a LCD panel where a semiconductor chip driving pixel circuits is mounted on a main surface of a first substrate which is exposed by recession of a second substrate, wire terminals connect to the semiconductor chip. A backlight is arranged to illumniate a back surface of the LCD panel. The device includes a flexible printed substrate having one end portion connected to wire terminals on the main surface of the ifrst substrate, and another end portion on which LEDs are mounted.

This document discloses the features of the preamble of claim 1.

US 2010/0110328 A1 discloses a liquid crystal display device in which a flexible printed circuit board is connected to a terminal portion of a TFT substrate. In the board, a light-emmitting-diode-use flexible printed circuit board is folded and extends towards a back surface of a backlight.

US 2006/0187373 A1 discloses an LCD module in which a circuit board is electrically connected to a LCD panel, and at least one point light source are attched at the circuit board and adjacent to the light guide plate.

US 2009/0310054 A1 discloses a LCD device provided with a flexible printed circuit (FPC) on a main support. The FPC is integrally formed with a color sensor for detect colors.

However these applications also cannot solve the technical problem as stated above, i.e. the thickness increase caused by the reinforcing plate.

### SUMMARY OF THE INVENTION

An object of the invention is to reduce damage to wiring while meeting the demand for a reduction in thickness.

The above object is achieved by the features of claim 1.
(1) A liquid crystal display device according to the invention includes: a liquid crystal display panel having a display surface and a rear surface opposite to the display surface; a light guide plate arranged so as to avoid a position below an edge of the liquid crystal display panel on the side of the rear surface of the liquid crystal display panel; a flexible wiring board having a portion arranged below the edge of the liquid crystal display panel with a gap disposed between the portion and the edge; a light source mounted, for introducing light to the light guide plate, on a surface of the flexible wiring board on the side of the liquid crystal display panel at a position below the edge of the liquid crystal display panel; and a reinforcing plate located next to the light source on the opposite side to the light guide plate and attached to the surface of the flexible wiring board where the light source is mounted. According to the invention, the reinforcing plate is attached to the surface of the flexible wiring board where the light source is mounted, so that the reinforcing plate can be contained inside the flexible wiring board to avoid an increase in thickness. Therefore, it is possible to reduce damage to the wiring while meeting the demand for a reduction in thickness.
(2) In the liquid crystal display device according to (1), the flexible wiring board may have a portion which is longer in a second direction than in a first direction between the light source and the reinforcing plate, the second direction being perpendicular to the first direction, and a plurality of the light sources may be mounted to be aligned in the second direction in the portion which is longer in the second direction.
(3) In the liquid crystal display device according to (2), the reinforcing plate may extend along the second direction, and the plurality of the light sources may be arranged to be shifted from the reinforcing plate in the first direction within a range of the length of the reinforcing plate in the second direction.
(4) In the liquid crystal display device according to (3), the reinforcing plate may be arranged in a shape in which the reinforcing plate extends between the light sources next to each other.
(5) In the liquid crystal display device according to any one of (1) to (4), the flexible wiring board may have a base material, wiring formed on the base material on the side where the light source is mounted, and a cover covering the wiring, the wiring may have a portion exposed from the cover, and the light source may be joined so as to be electrically connected to the portion of the wiring exposed from the cover.
(6) In the liquid crystal display device according to any one of (1) to (5), the flexible wiring board may include a joint portion with the liquid crystal display panel and a connection portion extending from the joint portion to the reinforcing plate and the mounting portion of the light source, and the connection portion may bend so that the exterior thereof is convex at the side of the liquid crystal display panel.
(7) In the liquid crystal display device according to any one of (1) to (6), the liquid crystal display device may further include a reflective sheet overlapping with the light guide plate on the opposite side to the liquid crystal display panel, the flexible wiring board may be arranged next to the reflective sheet while avoiding an overlap with the reflective sheet, and the flexible wiring board may be arranged so as not to project below a surface of the reflective sheet on the opposite side to the light guide plate.
(8) In the liquid crystal display device according to any one of (1) to (7), the liquid crystal display device may further include a frame supporting the edge of the liquid crystal display panel on the side of the rear surface and arranged so as to overlap with the reinforcing plate on the side of the liquid crystal display panel.
(9) In the liquid crystal display device according to (8), the frame may have a recess or cutout at a region facing the reinforcing plate.
(10) In the liquid crystal display device according to (8) or (9), the reinforcing plate may be attached to the frame.

### BRIEF DESCRIPTION OF THE DRAWINGS

Fig. 1 is a plan view showing a liquid crystal display device according to an embodiment of the invention.
Fig. 2 shows a back surface of the liquid crystal display device shown in Fig. 1.
Fig. 3 is a cross-sectional view of the liquid crystal display device shown in Fig. 1 taken along line III-III.
Fig. 4 shows the liquid crystal display device shown in Fig. 2 with a flexible wiring board unrolled.
Fig. 5 is an enlarged cross-sectional view of the liquid crystal display device shown in Fig. 4 taken along line V-V.
Fig. 6 shows a modified example of a reinforcing plate.

### DETAILED DESCRIPTION OF THE INVENTION

Hereinafter, an embodiment of the invention will be described with reference to the drawings.

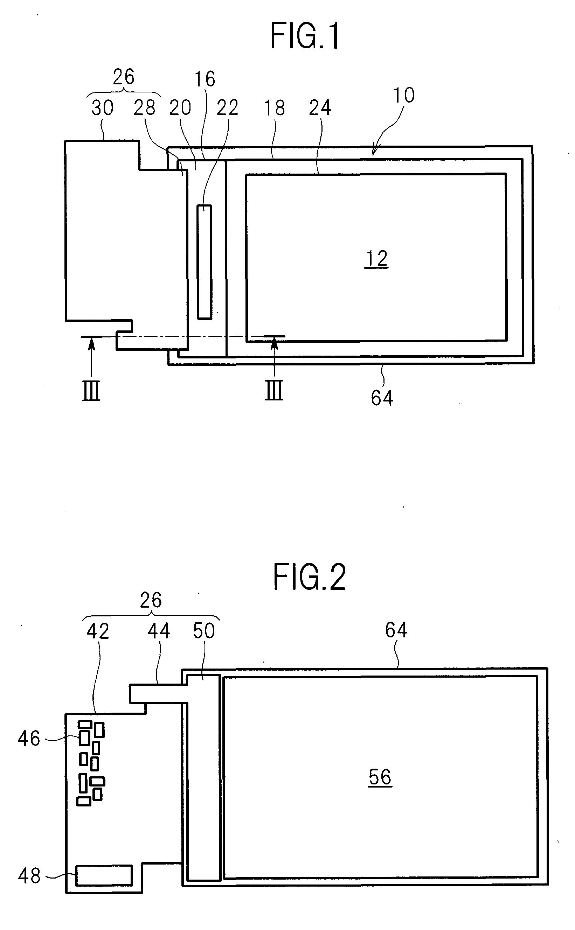

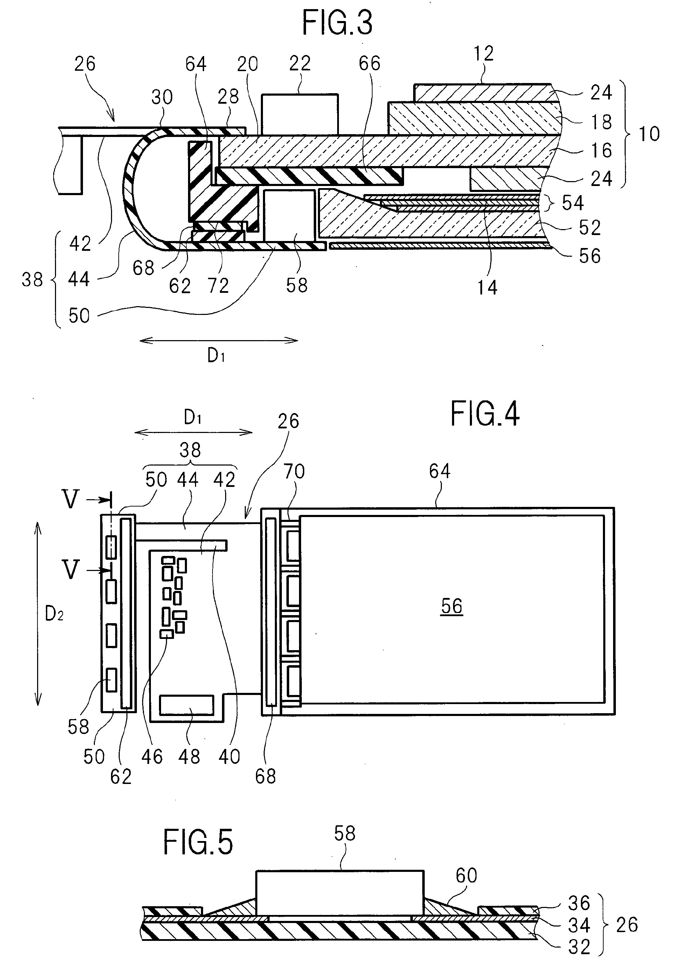

Fig. 1 is a plan view showing a liquid crystal display device according to the embodiment of the invention. Fig. 2 shows a back surface of the liquid crystal display device shown in Fig. 1. Fig. 3 is a cross-sectional view of the liquid crystal display device shown in Fig. 1 taken along line III-III.

The liquid crystal display device has a liquid crystal display panel 10. The liquid crystal display panel 10 has a display surface 12 for displaying an image and a rear surface 14 (refer to Fig. 3) opposite to the display surface 12. The liquid crystal display panel 10 has a pair of substrates 16 and 18 (both are glass substrates) and liquid crystal (not shown) interposed between the substrates. The substrate 16 is a TFT (Thin Film Transistor) substrate (or an array substrate) including thin film transistors, pixel electrodes, wiring, and the like, while the substrate 18 is a color filter substrate. The driving system of the liquid crystal display panel 10 may be any of an IPS (In-Plane Switching) system, TN (Twisted Nematic) system, VA (Vertical Alignment) system, or the like, and electrodes and wiring according to the system are formed.

The substrate 16 of the liquid crystal display panel 10 has a projecting portion 20 projecting from the other substrate. An integrated circuit chip 22 incorporating a driver circuit for driving the liquid crystal is mounted on the liquid crystal display panel 10 (specifically, the projecting portion 20). A polarizer 24 is attached to each of the pair of substrates 16 and 18 of the liquid crystal display panel 10.

A flexible wiring board 26 is fixed to the liquid crystal display panel 10 (specifically, the projecting portion 20). As shown in Fig. 3, the flexible wiring board 26 bends to extend from above the display surface 12 of the liquid crystal display panel 10 to below the rear surface 14. The flexible wiring board 26 has a portion arranged below an edge of the liquid crystal display panel 10 with a gap disposed between the portion and the edge. The flexible wiring board 26 includes a joint portion 28 with the liquid crystal display panel 10 and a connection portion 30 extending from the joint portion 28. The connection portion 30 is a portion of the flexible wiring board 26 other than the joint portion 28. The connection portion 30 bends so that the exterior thereof is convex at the side of the liquid crystal display panel 10.

Fig. 4 shows the liquid crystal display device shown in Fig. 2 with the flexible wiring board 26 unrolled. Fig. 5 is an enlarged cross-sectional view of the liquid crystal display device shown in Fig. 4 taken along line V-V. The flexible wiring board 26 has a base material 32 and wiring 34 formed on the base material 32. The wiring 34 is covered with a cover 36 (for example, solder resist). The wiring 34 has a portion exposed from the cover 36. The wiring 34 is electrically connected to the liquid crystal display panel 10.

As shown in Fig. 4, the flexible wiring board 26 has a main body 38 connected to the liquid crystal display panel 10. The main body 38 has a first portion 42 on one side and a second portion 44 on the other side via a slit 40 formed in a direction away from the liquid crystal display panel 10. On the first portion 42, electronic components 46, such as resistors and capacitors, and a connector 48 are mounted.

The flexible wiring board 26 (the main body 38) has a third portion 50 which is connected to the second portion 44 and longer in a second direction D₂ than in a first direction D₁. The first direction D₁ is a direction of the flexible wiring board 26 extending from the liquid crystal display panel 10, or a direction of the flexible wiring board 26 extending from the bending portion thereof to below the liquid crystal display panel 10. The second direction D₂ is a direction perpendicular to the first direction D₁.

The liquid crystal display device has a light guide plate 52. A surface of the light guide plate 52 faces the rear surface 14 of the liquid crystal display panel 10. The light guide plate 52 is arranged so as to avoid a position below the edge of the liquid crystal display panel 10 on the side of the rear surface 14 of the liquid crystal display panel 10.

A group of optical sheets 54 are arranged between the liquid crystal display panel 10 and the light guide plate 52. The group of optical sheets 54 includes a diffusion sheet and a prism sheet. Moreover, a reflective sheet 56 is arranged below the light guide plate 52 (on the opposite side to the group of optical sheets 54) .

The liquid crystal display device has light sources 58 (for example, light emitting diodes) for introducing light to the light guide plate 52. The light guide plate 52 converts light of the light source 58 as a point light source to a surface light source and emits the light to the liquid crystal display panel 10. The light source 58 faces an end face of the light guide plate 52.

The light sources 58 are mounted on a surface of the flexible wiring board 26 on the side of the liquid crystal display panel 10 at a position below the edge portion of the liquid crystal display panel 10. As shown in Fig. 5, the light source 58 is joined so as to be electrically connected to the portion of the wiring 34 exposed from the cover 36 formed in the flexible wiring board 26. The electrical connection and physical joint of the light source are made with solder 60. The plurality of light sources 58 are mounted to be aligned in the second direction D₂ in the third portion 50 of the flexible wiring board 26, the third portion 50 being long in the second direction D₂, (refer to Fig. 4).

To the flexible wiring board 26 (specifically, the third portion 50 thereof), a reinforcing plate 62 is attached. The reinforcing plate 62 is attached to the surface of the flexible wiring board 26 where the light sources 58 are mounted. The reinforcing plate 62 is located next to the light sources 58 on the opposite side to the light guide plate 52. The reinforcing plate 62 extends along the second direction D₂ (refer to Fig. 4). Moreover, the reinforcing plate 62 is formed along the second direction D₂ without interruption, and a side thereof extending along the second direction D₂ forms a straight line or curved line without projections or depressions.

The plurality of light sources 58 are arranged to be shifted from the reinforcing plate 62 in the first direction D₁ within a range of the length of the reinforcing plate 62 in the second direction D₂ (refer to Fig. 4). The first direction D₁ is also a direction between the light source 58 and the reinforcing plate 62. The reinforcing plate 62 may be formed of resin or metal, or may be formed of the same material as that of the base material 32 of the flexible wiring board 26.

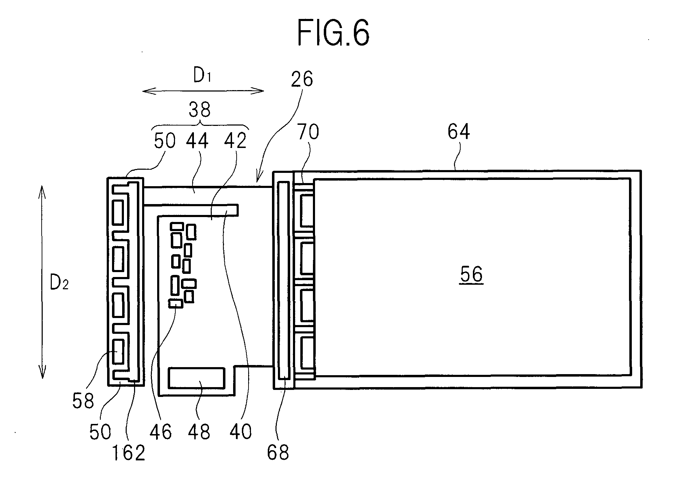

A reinforcing plate 162 shown in Fig. 6 as a modified example has a shape in which the reinforcing plate extends between the light sources 58 next to each other. As shown in Fig. 4, however, the reinforcing plate 62 having a shape in which the reinforcing plate is formed so as to avoid a position between the light sources 58 next to each other is advantageous in printing solder paste. That is, when solder paste is disposed on the wiring 34 by screen printing for joining the light sources 58, step portions due to the presence or absence of the reinforcing plate 62 are not formed in the second direction D₂ if the reinforcing plate 62 has the shape shown in Fig. 4, and therefore, a squeegee can be moved smoothly.

As shown in Fig. 3, the reflective sheet 56 is arranged so as to overlap with the light guide plate 52 on the opposite side to the liquid crystal display panel 10. The flexible wiring board 26 is arranged next to the reflective sheet 56 while avoiding an overlap with the reflective sheet 56.

The liquid crystal display device has a frame 64 made of, for example, resin. The liquid crystal display panel 10 is fixed to the frame 64. Specifically, the frame 64 has a frame shape, and the liquid crystal display panel 10 is attached to one surface of the frame so as to cover the inner space of the frame. For the attachment, a light-shielding double-faced tape 66 (refer to Fig. 3) is used. The frame 64 supports the edges of the liquid crystal display panel 10 on the side of the rear surface 14. The frame 64 is arranged so as to overlap with the reinforcing plate 62 on the side of the liquid crystal display panel 10. The reinforcing plate 62 is attached to the frame 64. For the attachment, a double-faced tape 68 is used. Moreover, another double-faced tape 70 (refer to Fig. 4) attaches the third portion 50 (portion being long in the second direction D₂) of the flexible wiring board 26 where the light sources 58 are mounted to the frame 64 at positions avoiding the light sources 58.

As shown in Fig. 3, the frame 64 has a recess or cutout 72 at a region facing the reinforcing plate 62. With the recess or cutout 72, the thickness of the reinforcing plate 62 is absorbed, and the downward bulging of the flexible wiring board 26 is prevented. The flexible wiring board 26 does not project below a surface of the reflective sheet 56 on the opposite side to the light guide plate 52.

According to the embodiment, the reinforcing plate 62 is attached to the surface of the flexible wiring board 26 where the light sources 58 are mounted, so that the reinforcing plate 62 can be contained inside the flexible wiring board to avoid an increase in thickness. With this configuration, it is possible to reduce damage to the wiring 34 while meeting the demand for a reduction in thickness.

The invention is not limited to the embodiment described above, but various kinds of modifications are possible as long as they fall within the scope of the claims. For example, the configuration described in the embodiment can be replaced by substantially the same configuration, a configuration providing the same operation and advantage, and a configuration capable of achieving the same object.

## Claims

1. A liquid crystal display device comprising:
a liquid crystal display panel (10) having a display surface (12) and a rear surface (14) opposite to the display surface;
a light guide plate (52) arranged on the side of the rear surface of the liquid crystal display panel but avoiding a position rearward of an edge region of the liquid crystal display panel;
a flexible wiring board (26) having a portion arranged rearward of said edge region with a gap disposed between the portion and the edge region; and
a light source (58) having a first side and an opposite second side and mounted for introducing light from its first side into the light guide plate and mounted on a surface of the flexible wiring board and at a position rearward of said edge region;
**characterised by** further comprising
a reinforcing plate (62, 162) located at the second side of the light source and attached to the surface of the flexible wiring board where the light source is mounted.

2. The liquid crystal display device according to claim 1, wherein
the flexible wiring board has a portion (50) which is longer in a second direction (D₂) than in a first direction (D₁) between the light source and the reinforcing plate, the second direction being perpendicular to the first direction, and
a plurality of the light sources (58) are mounted to be aligned in the second direction in the portion which is longer in the second direction.

3. The liquid crystal display device according to claim 2, wherein
the reinforcing plate extends along the second direction, and
the plurality of the light sources are arranged to be shifted from the reinforcing plate in the first direction within a range of the length of the reinforcing plate in the second direction.

4. The liquid crystal display device according to claim 3, wherein
the reinforcing plate is arranged in a shape in which the reinforcing plate extends between the light sources next to each other.

5. The liquid crystal display device according to any one of claims 1 to 4, wherein
the flexible wiring board has a base material (32), wiring (34) formed on the base material on the side where the light source is mounted, and a cover (36) covering the wiring,
the wiring has a portion exposed from the cover, and the light source is joined so as to be electrically connected to the portion of the wiring exposed from the cover.

6. The liquid crystal display device according to any one of claims 1 to 5, wherein
the flexible wiring board includes a joint portion (28) with the liquid crystal display panel and a connection portion (30) extending from the joint portion to the reinforcing plate and the mounting portion of the light source, and
the connection portion bends so that the exterior thereof is convex at the side of the liquid crystal display panel.

7. The liquid crystal display device according to any one of claims 1 to 6, further comprising a reflective sheet (56) overlapping with the light guide plate on the opposite side to the liquid crystal display panel, wherein
the flexible wiring board is arranged next to the reflective sheet while avoiding an overlap with the reflective sheet, and
the flexible wiring board is arranged so as not to project below a surface of the reflective sheet on the opposite side to the light guide plate.

8. The liquid crystal display device according to any one of claims 1 to 7, further comprising a frame (64) supporting the edge of the liquid crystal display panel on the side of the rear surface and arranged so as to overlap with the reinforcing plate on the side of the liquid crystal display panel.

9. The liquid crystal display device according to claim 8, wherein
the frame has a recess or cutout (72) at a region facing the reinforcing plate.

10. The liquid crystal display device according to claim 8 or 9, wherein
the reinforcing plate is attached to the frame.

## Patentansprüche

1. Flüssigkristallanzeigevorrichtung, die umfasst:
eine Flüssigkristallanzeigetafel (10) mit einer Anzeigeoberfläche (12) und einer hinteren Oberfläche (14) gegenüber der Anzeigeoberfläche;
eine Lichtführungsplatte (52), die auf der Seite der hinteren Oberfläche der Flüssigkristallanzeigetafel angeordnet ist, jedoch eine Position hinter einem Kantenabschnitt der Flüssigkristallanzeigetafel meidet;
eine biegsame Verdrahtungsplatte (26) mit einem Abschnitt, der hinter dem Kantenbereich angeordnet ist, wobei zwischen dem Abschnitt und dem Kantenbereich ein Spalt vorhanden ist; und
eine Lichtquelle (58), die eine erste Seite und eine gegenüberliegende zweite Seite besitzt und montiert ist, um Licht von ihrer ersten Seite in die Lichtführungsplatte einzuleiten, und auf einer Oberfläche der biegsamen Verdrahtungsplatte und an einer Position hinter dem Kantenbereich montiert ist;
**dadurch gekennzeichnet, dass** sie ferner umfasst:
eine Verstärkungsplatte (62, 162), die sich auf der zweiten Seite der Lichtquelle befindet und an der Oberfläche der biegsamen Verdrahtungsplatte, wo die Lichtquelle montiert ist, befestigt ist.

2. Flüssigkristallanzeigevorrichtung nach Anspruch 1, wobei
die biegsame Verdrahtungsplatte zwischen der Lichtquelle und der Verstärkungsplatte einen Abschnitt (50) besitzt, der in einer zweiten Richtung (D₂) länger ist als in einer ersten Richtung (D₁), wobei die zweite Richtung zu der ersten Richtung senkrecht ist, und
mehrere der Lichtquellen (58) so montiert sind, dass sie in dem Abschnitt, der in der zweiten Richtung länger ist, auf die zweite Richtung ausgerichtet sind.

3. Flüssigkristallanzeigevorrichtung nach Anspruch 2, wobei
die Verstärkungsplatte sich längs der zweiten Richtung erstreckt; und
die mehreren Lichtquellen so angeordnet sind, dass sie von der Verstärkungsplatte in der ersten Richtung innerhalb eines Bereichs der Länge der Verstärkungsplatte in der zweiten Richtung verschoben sind.

4. Flüssigkristallanzeigevorrichtung nach Anspruch 3, wobei
die Verstärkungsplatte in einer Form angeordnet ist, in der sich die Verstärkungsplatte zwischen den Lichtquellen, die sich am nächsten nebeneinander befinden, erstreckt.

5. Flüssigkristallanzeigevorrichtung nach einem der Ansprüche 1 bis 4, wobei
die biegsame Verdrahtungsplatte ein Grundmaterial (32), eine auf dem Grundmaterial gebildete Verdrahtung (34) auf der Seite, auf der die Lichtquelle montiert ist, und eine Abdeckung (36), die die Verdrahtung abdeckt, besitzt,
wobei die Verdrahtung einen von der Abdeckung nicht abgedeckten Abschnitt besitzt und
die Lichtquelle so verbunden ist, dass sie mit dem Abschnitt der Verdrahtung, der von der Abdeckung nicht abgedeckt ist, elektrisch verbunden ist.

6. Flüssigkristallanzeigevorrichtung nach einem der Ansprüche 1 bis 5, wobei
die biegsame Verdrahtungsplatte einen Verbindungsabschnitt (28) mit der Flüssigkristallanzeigetafel und einen Anschlussabschnitt (30), der sich von dem Verbindungsabschnitt zu der Verstärkungsplatte und dem Montageabschnitt der Lichtquelle erstreckt, enthält und
der Anschlussabschnitt gebogen ist, so dass seine Außenseite auf Seiten der Flüssigkristallanzeigetafel konvex ist.

7. Flüssigkristallanzeigevorrichtung nach einem der Ansprüche 1 bis 6, die ferner eine reflektierende Lage (56) umfasst, die mit der Lichtführungsplatte auf der der Flüssigkristallanzeigetafel gegenüberliegenden Seite überlappt, wobei
die biegsame Verdrahtungsplatte in der Nähe der reflektierenden Lage angeordnet ist, wobei eine Überlappung mit der reflektierenden Lage vermieden ist, und
die biegsame Verdrahtungsplatte in der Weise angeordnet ist, dass sie unter einer Oberfläche der reflektierenden Lage auf der der Lichtführungsplatte gegenüberliegenden Seite nicht vorsteht.

8. Flüssigkristallanzeigevorrichtung nach einem der Ansprüche 1 bis 7, die ferner einen Rahmen (64) umfasst, der die Kante der Flüssigkristallanzeigetafel auf der Seite der hinteren Oberfläche trägt und so angeordnet ist, dass er mit der Verstärkungsplatte auf der Seite der Flüssigkristallanzeigetafel überlappt.

9. Flüssigkristallanzeigevorrichtung nach Anspruch 8, wobei der Rahmen eine Aussparung oder einen Ausschnitt (72) in einem der Verstärkungsplatte zugewandten Bereich besitzt.

10. Flüssigkristallanzeigevorrichtung nach Anspruch 8 oder 9, wobei die Verstärkungsplatte an dem Rahmen befestigt ist.

## Revendications

1. Dispositif d'affichage à cristaux liquides comprenant :
un panneau (10) d'affichage à cristaux liquides ayant une surface (12) d'affichage et une surface (14) arrière opposée à la surface d'affichage ;
une plaque-guide (52) de lumière agencée sur le côté de la surface arrière du panneau d'affichage à cristaux liquides mais évitant une position en arrière d'une région de bord du panneau d'affichage à cristaux liquides ;
une carte de connexion (26) flexible ayant une partie agencée en arrière de ladite région de bord avec un espace disposé entre la partie et la région de bord ; et
une source (58) de lumière ayant un premier côté et un deuxième côté opposé et montée de façon à introduire une lumière par son premier côté dans la plaque-guide de lumière et montée sur une surface de la carte de connexion flexible et en une position en arrière de ladite région de bord ;
**caractérisé en ce que** comprenant en outre
une plaque (62, 162) de renfort située au niveau du deuxième côté de la source de lumière et fixée à la surface de la carte de connexion flexible où la source de lumière est montée.

2. Dispositif d'affichage à cristaux liquides selon la revendication 1, dans lequel
la carte de connexion flexible a une partie (50) qui est plus longue dans un deuxième sens (D₂) que dans un premier sens (D₁) entre la source de lumière et la plaque de renfort, le deuxième sens étant perpendiculaire au premier sens, et
une pluralité des sources (58) de lumière sont montées de façon à être alignées dans le deuxième sens dans la partie qui est plus longue dans le deuxième sens.

3. Dispositif d'affichage à cristaux liquides selon la revendication 2, dans lequel
la plaque de renfort s'étend dans le deuxième sens, et
la pluralité des sources de lumière sont agencées de façon à être décalées par rapport à la plaque de renfort dans le premier sens à l'intérieur d'une plage de la longueur de la plaque de renfort dans le deuxième sens.

4. Dispositif d'affichage à cristaux liquides selon la revendication 3, dans lequel
la plaque de renfort est agencée à une forme dans laquelle la plaque de renfort s'étend entre les sources de lumière les unes à côté des autres.

5. Dispositif d'affichage à cristaux liquides selon l'une quelconque des revendications 1 à 4, dans lequel
la carte de connexion flexible a un matériau (32) de base, un câblage (34) formé sur le matériau de base sur le côté où la source de lumière est montée, et un capot (36) recouvrant le câblage,
le câblage a une partie exposée hors du capot, et
la source de lumière est jointe de façon à être électriquement connectée à la partie du câblage exposée hors du capot.

6. Dispositif d'affichage à cristaux liquides selon l'une quelconque des revendications 1 à 5, dans lequel
la carte de connexion flexible inclut une partie (28) de jonction avec le panneau d'affichage à cristaux liquides et une partie (30) de connexion s'étendant de la partie de jonction jusqu'à la plaque de renfort et la partie de montage de la source de lumière, et
la partie de connexion est courbe, de façon à ce que l'extérieur de celle-ci soit convexe au niveau du côté du panneau d'affichage à cristaux liquides.

7. Dispositif d'affichage à cristaux liquides selon l'une quelconque des revendications 1 à 6, comprenant en outre une feuille (56) réfléchissante se chevauchant avec la plaque-guide de lumière sur le côté opposé au panneau d'affichage à cristaux liquides, dans lequel
la carte de connexion flexible est agencée à côté de la feuille réfléchissante tout en évitant un chevauchement avec la feuille réfléchissante, et
la carte de connexion flexible est agencée de façon à ne pas se projeter en-dessous d'une surface de la feuille réfléchissante sur le côté opposé à la plaque-guide de lumière.

8. Dispositif d'affichage à cristaux liquides selon l'une quelconque des revendications 1 à 7, comprenant en outre un cadre (64) supportant le bord du panneau d'affichage à cristaux liquides sur le côté de la surface arrière et agencé de façon à se chevaucher avec la plaque de renfort sur le côté du panneau d'affichage à cristaux liquides.

9. Dispositif d'affichage à cristaux liquides selon la revendication 8, dans lequel
le cadre a un évidement ou une découpe (72) au niveau d'une région faisant face à la plaque de renfort.

10. Dispositif d'affichage à cristaux liquides selon la revendication 8 ou 9, dans lequel
la plaque de renfort est fixée au cadre.
